(19) Europäisches Patentamt

European Patent Office

Office européen des brevets

(11) **EP 0 740 413 B1**

(12) **FASCICULE DE BREVET EUROPEEN**

(45) Date de publication et mention
de la délivrance du brevet:
**02.08.2000   Bulletin 2000/31**

(51) Int Cl.⁷: **H03H 11/12**

(21) Numéro de dépôt: **96410036.6**

(22) Date de dépôt: **24.04.1996**

(54) **Filtre actif différentiel du second ordre**

Aktives differentiales Filter zweiter Ordnung

Second order active differential filter

(84) Etats contractants désignés:
**DE FR GB IT**

(30) Priorité:  **26.04.1995  FR 9505239**

(43) Date de publication de la demande:
**30.10.1996   Bulletin 1996/44**

(73) Titulaire: **STMicroelectronics S.A.**
**94250 Gentilly (FR)**

(72) Inventeurs:
• **Federspiel, Lionel**
**38100 Grenoble (FR)**
• **Perrin, Christian**
**38450 Saint Georges de Commiers (FR)**

(74) Mandataire: **de Beaumont, Michel**
**1bis, rue Champollion**
**38000 Grenoble (FR)**

(56) Documents cités:
**EP-A- 0 345 880         EP-A- 0 421 530**

**Description**

La présente invention concerne un filtre actif destiné à traiter des signaux différentiels.

Dans des applications où l'on souhaite que des signaux soient peu sensibles au bruit, ces signaux sont transmis sur deux voies de manière différentielle. L'immunité au bruit des signaux est alors augmentée pour plusieurs raisons, notamment grâce au fait que les signaux ne sont plus référencés par rapport à un potentiel d'alimentation (souvent la masse), qui est susceptible d'être particulièrement bruité.

Pour réaliser un filtrage d'un signal différentiel, notamment du deuxième ordre ou d'ordre plus élevé, une solution classique consiste à filtrer chacune des deux composantes du signal différentiel par un filtre non différentiel.

Ce filtrage a l'inconvénient de nécessiter deux amplificateurs et de ne pas être immunisé contre le bruit de masse puisqu'au moins une impédance de chaque filtre non différentiel est connectée à la masse. En outre, il est difficile de respecter une relation de phase précise entre les deux composantes filtrées.

Les filtres différentiels sont souvent utilisés dans des interfaces entre signal différentiel et signal non-différentiel. Ces interfaces sont complexes, notamment dans le cas du passage d'un signal non-différentiel à un signal différentiel, car il faut garantir une relation de phase précise entre les deux composantes différentielles et une variation symétrique des composantes alternatives par rapport à un mode commun prédéterminé. D'autres filtres différentiels sont connus du document EP-A- 0 421 530.

Un objet de la présente invention est de prévoir un filtre différentiel du second ordre, au moins, utilisant un seul amplificateur et garantissant une immunité au bruit de masse ou de l'alimentation en général.

Un autre objet de la présente invention est de prévoir un tel filtre qui permette de réaliser une interface simple entre un signal non-différentiel et un signal différentiel.

Pour atteindre ces objets, l'invention prévoit de disposer un réseau de filtrage sur l'une des deux voies différentielles d'un amplificateur différentiel équilibré et de répéter ce réseau symétriquement sur l'autre voie différentielle. Une connexion particulière de certaines impédances des réseaux permet d'éviter toute connexion du filtre à un potentiel d'alimentation, tout en réalisant une fonction de transfert souhaitée.

L'invention vise plus particulièrement un filtre à amplificateur différentiel avec deux voies en opposition de phase. Chacune des voies comporte un même réseau de composants passifs comprenant deux impédances en série entre une borne d'entrée du filtre et une entrée correspondante de l'amplificateur différentiel, une impédance de réaction connectée entre le point commun de ces deux impédances en série et la sortie de la même voie de l'amplificateur différentiel, et une impédance de contre-réaction connectée entre une entrée de l'amplificateur différentiel et la sortie de l'autre voie de l'amplificateur différentiel.

Selon un mode de réalisation de la présente invention, l'impédance de contre-réaction comprend une résistance et un condensateur connectés en parallèle.

Selon un mode de réalisation de la présente invention, les impédances en série sont deux résistances et l'impédance de réaction est un condensateur.

Selon un mode de réalisation de la présente invention, les impédances en série sont deux condensateurs et l'impédance de réaction est une résistance.

Selon un mode de réalisation de la présente invention, parmi les deux impédances en série, celle connectée à une borne d'entrée du filtre est une résistance et celle connectée à une entrée correspondante de l'amplificateur différentiel est un condensateur, l'impédance de réaction étant une résistance.

Un filtre selon l'invention peut être utilisé pour convertir un signal simple en un signal différentiel. Alors, une borne d'entrée du filtre est connectée à une tension continue, l'autre borne d'entrée du filtre recevant le signal simple.

Ces objets, caractéristiques et avantages ainsi que d'autres de la présente invention seront exposés en détail dans la description suivante de modes de réalisation particuliers, faite à titre non-limitatif à l'aide des figures jointes parmi lesquelles :

La figure 1 représente un mode de réalisation de filtre passe-bas selon l'invention ;
la figure 2 représente un mode de réalisation de filtre passe-haut selon l'invention ; et
la figure 3 représente un mode de réalisation de filtre passe-bande selon l'invention.

Dans les figures, un filtre différentiel selon l'invention comprend un amplificateur différentiel équilibré 10 ayant deux entrées différentielles, I et I*, et deux sorties différentielles correspondantes, O et O*. Un premier réseau comprend des impédances de réaction et de contre-réaction connectées à l'une des entrées différentielles et aux deux sorties différentielles de l'amplificateur. Un autre réseau identique est connecté symétriquement à l'autre entrée différentielle et aux deux sorties différentielles.

L'ensemble du filtre comporte deux bornes d'entrée différentielles, A et A*, pour appliquer les composantes respectives d'un signal d'entrée différentiel. Deux bornes de sortie différentielles, B et B*, coïncidant respectivement avec les bornes de sortie, O et O*, de l'amplificateur différentiel, fournissent les composantes respectives du signal de sortie différentiel.

Ainsi, la liaison A-B forme une première voie de filtrage, et la liaison A*-B* forme une seconde voie de filtrage.

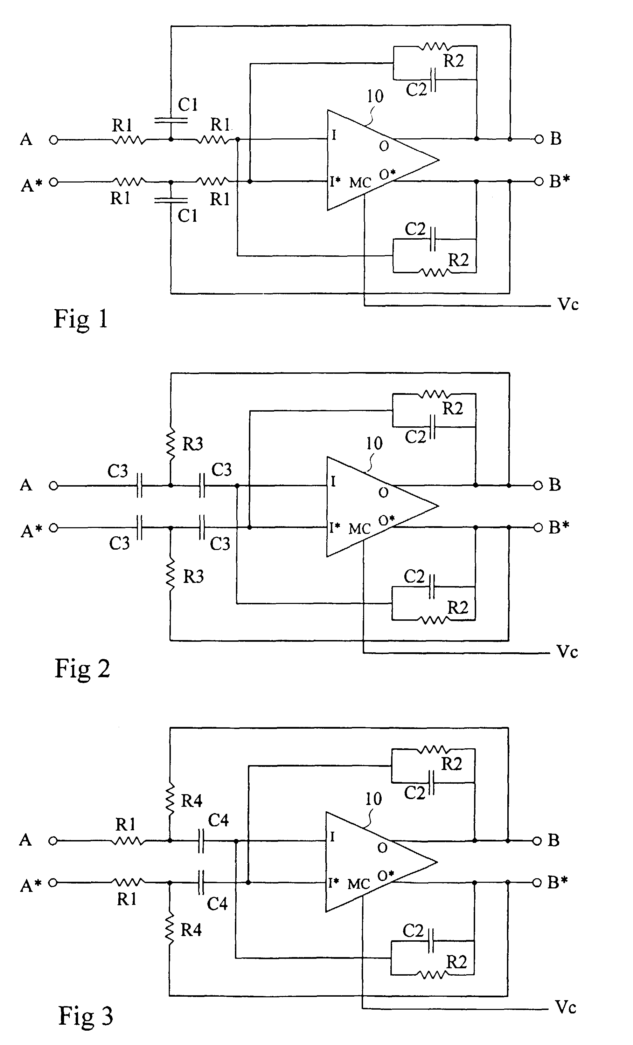

Dans la figure 1, représentant un filtre passe-bas selon l'invention, deux résistances identiques R1 sont connectées en série entre la borne A et la première entrée différentielle I de l'amplificateur différentiel 10. Un condensateur de réaction C1 est connecté entre la première sortie différentielle O et le point commun entre les deux résistances R1. Un circuit de contre-réaction est connecté entre l'entrée différentielle I de l'amplificateur différentiel et la seconde sortie différentielle O*. Ce circuit de contre-réaction comprend une résistance R2 et un condensateur C2 connectés en parallèle. L'ensemble du circuit formé des deux résistances R1, du condensateur de réaction C1, de la résistance R2 et du condensateur C2 de contre-réaction constitue le réseau de filtrage de la première voie.

Le réseau de filtrage de la seconde voie est constitué de façon similaire. Deux résistances R1 sont connectées en série entre la borne A* et l'entrée I* de l'amplificateur. Un condensateur C1 est connecté entre la seconde sortie O* et le point commun de ces deux résistances R1. Une résistance R2 et un condensateur C2 sont connectés en parallèle entre l'entrée I* et la première sortie différentielle 0.

Si on souhaite un gain égal à 1, on choisit les résistances R1 et R2, par exemple, telles que R2=2R1=2R. La fonction de transfert obtenue pour ce filtre est alors :

$$F_L(p) = \frac{1}{1 + (2R.C2 - \frac{1}{2}R.C1)p + R^2.C1.C2.p^2} \qquad (1)$$

où p est l'opérateur de Laplace.

On en déduit la fréquence de coupure (fréquence à laquelle le filtre a une atténuation de 3 dB) :

$$f_L = \frac{1}{2\pi R\sqrt{C1.C2}} \qquad (2)$$

et on obtient le facteur de qualité du filtre :

$$Q_L = \frac{\sqrt{C1.C2}}{(2C2 - \frac{1}{2}C1)} \qquad (3)$$

Comme l'indiquent les relations précédentes, le filtre différentiel du second ordre selon l'invention permet un réglage simple et indépendant de la fréquence de coupure et du facteur de qualité. Le facteur de qualité, selon la relation (3), est réglé en changeant la valeur d'un condensateur C1 ou C2 tandis que la fréquence de coupure est réglée en changeant la valeur R (relation (2)).

La figure 2 représente un mode de réalisation de filtre différentiel passe-haut selon l'invention. Les résistances R1 de la figure 1 ont été remplacées par des condensateurs C3, et le condensateur C1 de la figure 1 par une résistance R3.

Si on souhaite un gain égal à 1, on choisit les condensateurs C2 et C3, par exemple, tels que C3=2C2=2C. La fonction de transfert obtenue pour ce filtre passe-haut est alors :

$$F_H(p) = \frac{4.R3.R2.C^2.p^2}{1 + (4.R3.C - R2.C)p + 4.R3.R2.C^2.p^2}$$

L'homme du métier pourra déduire de cette relation la fréquence de coupure et le facteur de qualité, et remarquer qu'ils peuvent être réglés indépendamment l'un de l'autre.

La figure 3 représente un mode de réalisation de filtre différentiel passe-bande selon l'invention. Par rapport à la figure 1, les condensateurs C1 ont été remplacés par des résistances R4, et les résistances R1 reliées aux entrées I et I* ont été remplacées par des condensateurs C4.

La fonction de transfert de ce filtre passe-bande est ainsi :

$$F_B(p) = \frac{R2.R4.C4.p}{R1.R2.R4.C4.C2.p^2+(R1.R4.C4+R1.R2.C2+R2.R4.C2)p+R1+R4}$$

L'homme du métier pourra déduire de cette relation la fréquence de coupure et le facteur de qualité, et remarquer qu'ils peuvent être réglés indépendamment l'un de l'autre.

Une propriété d'un amplificateur différentiel équilibré classique est de fournir un couple de signaux ayant des composantes alternatives strictement en opposition de phase, et ayant des composantes continues identiques, égales à une tension appelée tension de mode commun Vc que l'on peut généralement choisir. Cette tension Vc est alors appliquée, comme cela est représenté dans les figures, à une entrée de mode commun (MC) de l'amplificateur différentiel 10.

Les filtres décrits peuvent en outre être avantageusement utilisés directement pour convertir un signal simple (non-différentiel) en signal différentiel. Dans ce cas, le signal simple est appliqué par exemple à l'entrée A, et l'entrée A* est connectée à la tension de mode commun Vc. Ainsi, le signal simple est converti en un signal différentiel idéal ayant un mode commun correspondant à la tension Vc.

Inversement, les filtres peuvent être utilisés pour convertir un signal différentiel en un signal simple, en utilisant une seule des sorties B, B*, le signal simple étant référencé, par exemple, par rapport à la tension de mode commun Vc.

## Revendications

1. Filtre à amplificateur différentiel (10) avec deux voies en opposition de phase, caractérisé en ce que chacune des voies comporte un même réseau de composants passifs comprenant :

   - deux impédances en série (R1) entre une borne d'entrée (A) du filtre et une entrée correspondante (I) de l'amplificateur différentiel,
   - une impédance de réaction connectée entre le point commun de ces deux impédances en série (R1) et la sortie (O) de la même voie de l'amplificateur différentiel, et
   - une impédance de contre-réaction (R2, C2) connectée entre une entrée (I) de l'amplificateur différentiel et la sortie (O∗) de l'autre voie de l'amplificateur différentiel.

2. Filtre selon la revendication 1, caractérisé en ce que l'impédance de contre-réaction comprend une résistance (R2) et un condensateur (C2) connectés en parallèle.

3. Filtre selon la revendication 1 ou 2, caractérisé en ce que lesdites impédances en série sont deux résistances (R1), et en ce que l'impédance de réaction est un condensateur (C1), afin de réaliser un filtre passe-bas.

4. Filtre selon la revendication 1 ou 2, caractérisé en ce que lesdites impédances en série sont deux condensateurs (C3), et en ce que l'impédance de réaction est une résistance (R3), afin de réaliser un filtre passe-haut.

5. Filtre selon la revendication 1 ou 2, caractérisé en ce que, parmi les deux impédances en série, celle connectée à une borne d'entrée du filtre est une résistance (R1) et celle connectée à une entrée correspondante de l'amplificateur différentiel est un condensateur (C4), l'impédance de réaction étant une résistance (R4), afin de réaliser un filtre passe-bande.

6. Utilisation du filtre selon la revendication 1 pour convertir un signal simple en un signal différentiel, caractérisée par la connexion d'une borne d'entrée du filtre à une tension continue (Vc), l'autre borne d'entrée du filtre recevant le signal simple.

## Patentansprüche

1. Differenzverstärkerfilter (10) mit zwei Kanälen mit eingesetzter Phase, dadurch **gekennzeichnet**, daß jeder Kanal das gleiche Netzwerk aus passiven Bauelementen aufweist, wobei das Netzwerk umfaßt:

   - zwei in Serie geschaltete Impedanzen (R1) zwischen einem Eingangsanschluß (A) des Filters und einem entsprechenden Eingang (I) des Differenzverstärkers,
   - eine mitgekoppelte Impedanz, die zwischen dem gemeinsamen Anschluß der zwei in Serie geschalteten Impedanzen (R1) und dem Ausgang (O) des gleichen Kanals des Differenzverstärkers angeschlossen ist, und
   - eine gegengekoppelte Impedanz (R2, C2), die zwischen einem Eingang (I) des Differenzverstärkers und dem Ausgang (O*) des anderen Kanals des Differenzverstärkers angeschlossen ist.

**2.** Filter nach Anspruch 1, dadurch **gekennzeichnet**, daß die gegengekoppelte Impedanz einen Widerstand (R2) und einen Kondensator (C2) aufweist, die parallel geschaltet sind.

**3.** Filter nach Anspruch 1 oder 2, dadurch **gekennzeichnet**, daß die in Serie geschalteten Impendanzen zwei Widerstände (R1) sind und die mitgekoppelte Impedanz ein Kondensator (C1) ist, um ein Tiefpaßfilter zu bilden.

**4.** Filter nach Anspruch 1 oder 2, dadurch **gekennzeichnet**, daß die in Serie geschalteten Impedanzen zwei Kondensatoren (C3) sind und die mitgekoppelte Impedanz ein Widerstand (R3) ist, um ein Hochpaßfilter zu bilden.

**5.** Filter nach Anspruch 1 oder 2, dadurch **gekennzeichnet**, daß zwischen den zwei in Serie geschalteten Impedanzen, die Impendanz, die mit einen Eingangsanschluß des Filters verbunden ist, ein Widerstand (R1) ist und die Impedanz, die mit einem entsprechenden Eingang des Differenzverstärkers verbunden ist, ein Kondenstator (C4) ist, wobei die mitgekoppelte Impedanz ein Widerstand (R4) ist, um ein Bandfilter zu bilden.

**6.** Verwendung des Filters nach Anspruch 1, zum Konvertieren eines einfachen Signals in ein Differentialsignal, dadurch **gekennzeichnet**, daß ein Eingangsanschluß des Filters mit einer Gleichspannung (Vc) verbunden ist und der andere Eingangsanschluß des Filters das einfache Signal empfängt.

**Claims**

**1.** A differential amplifier filter (10) with two channels in phase opposition, characterized in that each channel includes the same network of passive components comprising:

- two impedances (R1) in series between an input terminal (A) of the filter and the corresponding input (I) of the differential amplifier,
- a feed-forward impedance connected between the common node of said two series impedances (R1) and the output (O) of the same channel of the differential amplifier, and
- a negative feedback impedance (R2, C2) connected between an input (I) of the differential amplifier and the output (O*) of the other channel of the differential amplifier.

**2.** The filter of claim 1, characterized in that the negative feedback impedance includes a resistor (R2) and a capacitor (C2) connected in parallel.

**3.** The filter of claim 1 or 2, characterized in that said series impedances are two resistors (R1) and the feedback impedance is a capacitor (C1), so as to form a low-pass filter.

**4.** The filter of claim 1 or 2, characterized in that said series impedances are two capacitors (C3) and the feedback impedance is a resistor (R3), so as to form a high-pass filter.

**5.** The filter of claim 1 or 2, characterized in that, among the two series impedances, the impedance connected to an input terminal of the filter is a resistor (R1) and the impedance connected to a corresponding input of the differential amplifier is a capacitor (C4), the feedback impedance being a resistor (R4), so as to form a pass-band filter.

**6.** Utilization of the filter of claim 1 for changing a simple signal into a differential signal, characterized in that an input terminal of the filter is connected to a d.c. voltage (Vc), the other input terminal of the filter receiving the simple signal.

Fig 1

Fig 2

Fig 3